# EUROPEAN PATENT SPECIFICATION

(11) **EP 2 009 802 B1**
(45) Date of publication and mention of the grant of the patent: **06.01.2016**
(21) Application number: 08011700.5
(22) Date of filing: 27.06.2008
(51) Int. Cl.: H04B 1/00, H01H 59/00, H01H 1/00, B81C 1/00

(54) **Variable circuit, communication apparatus, mobile communication apparatus and communication system**
Variable Schaltung, Kommunikationsvorrichtung, mobile Kommunikationsvorrichtung und Kommunikationssystem
Circuit variable, appareil de communication, appareil de communication mobile et système de communication

(30) Priority: 27.06.2007 JP 2007168672; 10.04.2008 JP 2008102528
(43) Date of publication of application: 31.12.2008
(73) Proprietor: NTT DOCOMO, INC., Chiyoda-ku Tokyo 100-6150 (JP)
(72) Inventor: Furuta, Takayuki, Tokyo 100-6150 (JP); Fukuda, Atsushi, Tokyo 100-6150 (JP); Okazaki, Hiroshi, Tokyo 100-6150 (JP); Narahashi, Shoichi, Tokyo 100-6150 (JP)
(74) Representative: MERH-IP Matias Erny Reichl Hoffmann Patentanwälte PartG mbB

(56) References cited:
- EP-A1- 1 764 952
- EP-A2- 1 486 999
- WO-A1-00/39915
- WO-A2-2004/021382
- US-A1- 2002 101 907
- US-A1- 2003 078 037
- US-A1- 2004 204 013
- CLARK T-C NGUYEN ET AL: "Micromachined Devices for Wireless Communications" PROCEEDINGS OF THE IEEE, IEEE. NEW YORK, US, vol. 86, no. 8, 1 August 1998 (1998-08-01) , XP011044074 ISSN: 0018-9219

## Description

### TECHNICAL FIELD

The present invention relates to a variable circuit having a characteristic that varies depending on the mechanical state of a MEMS switch having a mechanical operating mechanism.

### BACKGROUND ART

Micro electro mechanical systems (MEMS) devices are devices having a fine mechanical operating mechanism and are used in portable video game machines, liquid crystal projectors and car navigation systems, for example. In recent years, MEMS devices that have low loss in the radio frequency band have been developed, and application of those MEMS devices to radio-frequency (RF) circuits, such as filters and amplifiers, is being contemplated. For example, in the Non-Patent literature 1, there is described a multi-band amplifier that optimally operates at a plurality of frequencies by using the good characteristics in the radio frequency band of a MEMS switch. In the literature, a matching circuit incorporates a MEMS switch, and the circuit constant is changed by changing the state of the switch. Here, the MEMS switch is an ultraminiature relay having a size of several millimeters or less on a side. At least one of the contacts is mechanically driven to turn the MEMS on and off. Therefore, low-loss and high-isolation characteristics can be achieved over a wider range than conventional semiconductor switches. In the Non-Patent literature 1, the state of the switch is changed when the frequency characteristics is changed.
Non-Patent literature 1: Atsushi FUKUDA et al. "Multi-band Power Amplifier Employing MEMS Switches for Optimum Matching", page 39 (C-2-4), 2004 IEICE (The Institute of Electronics, Information and Communication Engineers) General Conference.

### DISCLOSURE OF THE INVENTION

### ISSUES TO BE SOLVED BY THE INVENTION

In the multi-band amplifier disclosed in the Non-Patent literature 1, the device is a MEMS switch, and the multi-band amplifier is made to operate at a predetermined frequency by turning the MEMS switch to the ON state. If the multi-band amplifier operates at that frequency for a long time, the MEMS switch is maintained in the ON state all the time. However, if a structure having a mechanical operating mechanism, such as a relay, is maintained in a certain state for a long time, mechanical deformation or fixation of a contact part can occur due to burning. As a result, a problem, such as failure of the MEMS switch, can occur. In addition, the MEMS switch uses a mechanical driving mechanism and extremely small and thin components. Therefore, compared with a machine of moderate size, mechanical deformation or the fixation of a contact part can occur in a short time. If such a phenomenon occurs, the MEMS switch described in the Non-Patent literature 1 becomes unable to switch the frequency or achieve the designed characteristics at the desired frequency.

An object of the present invention is to provide a variable circuit, a that prevents a phenomenon, such as mechanical deformation or fixation of a contact part of a MEMS switch.

### MEANS TO SOLVE ISSUES

The present invention provides a variable circuit according to claim 1. Further advantageous embodiments are disclosed in the dependent claims.

### EFFECTS OF THE INVENTION

With such a configuration, the mechanical state of the MEMS switch is changed at various timings that have no adverse effect on the processing, and thus, mechanical deformation or fixation, which occurs if the MEMS switch is maintained in a certain state for a long time, can be prevented.

### BRIEF DESCRIPTION OF THE DRAWINGS

Fig. 1 is a diagram showing a functional configuration of a variable circuit 510;
Fig. 2 is a detailed diagram showing a switch 24;
Fig. 3 is a diagram showing a functional configuration of a variable circuit 511;
Fig. 4 is a diagram showing a functional configuration of a variable circuit 520;
Fig. 5 is a diagram illustrating the state of switches as a function of time in a case where one frequency band is used;
Fig. 6 is a diagram illustrating the state of the switches as a function of time in a case where two frequency bands are used;
Fig. 7 is a diagram showing a functional configuration of a variable circuit 522;
Fig. 8 is a diagram illustrating the state of switches as a function of time in a case where the variable circuit 522 uses one frequency band;
Fig. 9 is a diagram illustrating the state of the switches as a function of time in a case where the variable circuit 522 uses two frequency bands;
Fig. 10 is a diagram showing a functional configuration of a communication apparatus 50 and a mobile communication apparatus 60;
Fig. 11 is a diagram for illustrating a packet transmission period;
Fig. 12 is a diagram for illustrating switching of a base station with which the mobile communication apparatus 60 communicates;
Fig. 13 is a diagram showing a functional configuration of a mobile communication apparatus 70;
Fig. 14 is a diagram showing a functional configuration of a mobile communication apparatus 75;
Fig. 15 is a diagram showing a functional configuration of a mobile communication apparatus 80;
Fig. 16 is a diagram showing a functional configuration of a mobile communication apparatus 90;
Fig. 17 is a diagram showing a functional configuration of a communication system 100;
Fig. 18A is a detailed diagram showing a switch 200;
Fig. 18B is a diagram showing an OFF state of the switch 200;
Fig. 18C is a diagram showing an ON state 1 of the switch 200;
Fig. 18D is a diagram showing an ON state 2 of the switch 200;
Fig. 19A is a detailed diagram showing a switch 210;
Fig. 19B is a diagram showing an OFF state of the switch 210;
Fig. 19C is a diagram showing an ON state 1 of the switch 210;
Fig. 19D is a diagram showing an ON state 2 of the switch 210; and
Fig. 19E is a diagram showing an ON state 3 of the switch 210.

### BEST MODE FOR CARRYING OUT THE INVENTION

In the following, best modes for carrying out the present invention will be described. Components that have the same function or carry out the same processing will be denoted by the same reference numerals, and redundant description thereof will be omitted.

### [Embodiment 1]

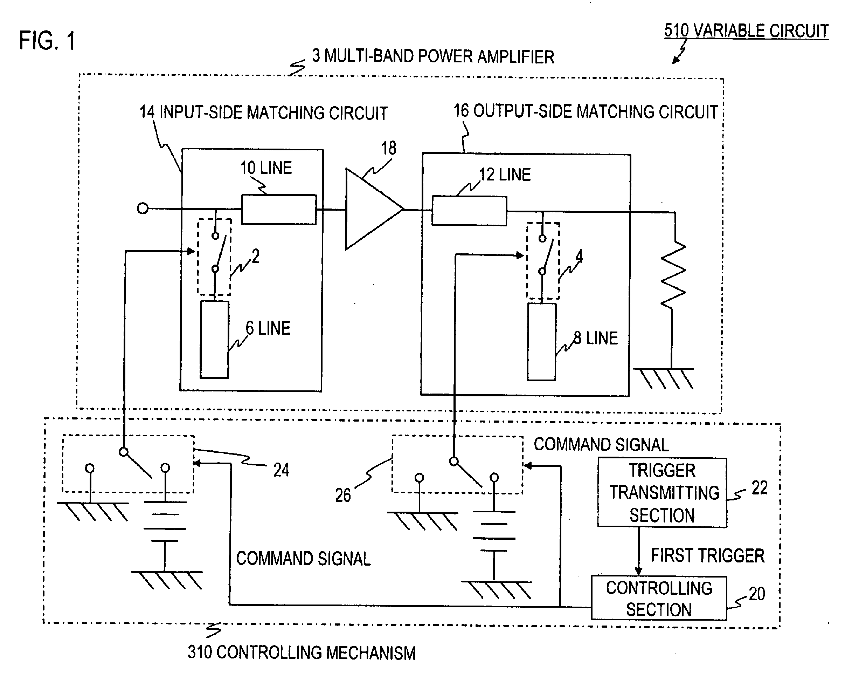

Fig. 1 is a diagram showing a functional configuration of a variable circuit 510 according to an embodiment 1. In the following, a case where a device having a mechanical operating mechanism is a MEMS switch will be described. It is supposed that a current mechanical state (referred to as "current state" hereinafter) is the ON state, and a state different from the current state (referred to as "different state" hereinafter) is the OFF state. In the drawings, the MEMS switch is described simply as "switch". The variable circuit 510 is an example of an RF circuit element and has a multi-band power amplifier 3 and a controlling mechanism 310. The multi-band power amplifier 3 has a single-band PA 18, an input-side matching circuit 14 and an output-side matching circuit 16. The single-band PA 18 operates at a single frequency. The single-band PA 18 is connected to the input-side matching circuit 14 and the output-side matching circuit 16 at the opposite ends thereof. The input-side matching circuit 14 has a switch 2 and lines 6 and 10. The output-side matching circuit 16 has a switch 4 and lines 8 and 12. The frequency characteristics of the input-side matching circuit 14 and the output-side matching circuit 16 can be changed using the switches 2 and 4, respectively. The multi-band power amplifier 3 operates at a frequency f2 when both the switches 2 and 4 are in the ON state and operates at a frequency f1 when both the switches 2 and 4 are in the OFF state. The switches 2 and 4 are turned to the ON state (current state) when a voltage V is applied to a control terminal thereof (not shown) and turned to the OFF state (different state) when the voltage is not applied to the control terminal. The lines 6, 8, 10 and 12 are designed to be matched with each other at the frequency f2. A method of designing the multi-band power amplifier 3 is described in detail in the Non-Patent literature 1 described above.

Next, the controlling mechanism 310 will be described. The controlling mechanism 310 has switches 24 and 26, a controlling section 20, and a trigger transmitting section 22. The controlling section 20 turns the switches 2 and 4 from the ON state to the OFF state or returns the switches 2 and 4 from the OFF state to the ON state. The trigger transmitting section 22 transmits a first trigger to turn the switches 2, 4 from the ON state to the OFF state to the controlling section 20 when a predetermined condition is satisfied. The "predetermined condition" is that a predetermined time elapses or an external input occurs, for example. Upon receipt of the first trigger, the controlling section 20 transmits a command signal to the switches 24 and 26. A common command signal or different command signals can be transmitted to the switches 24 and 26.

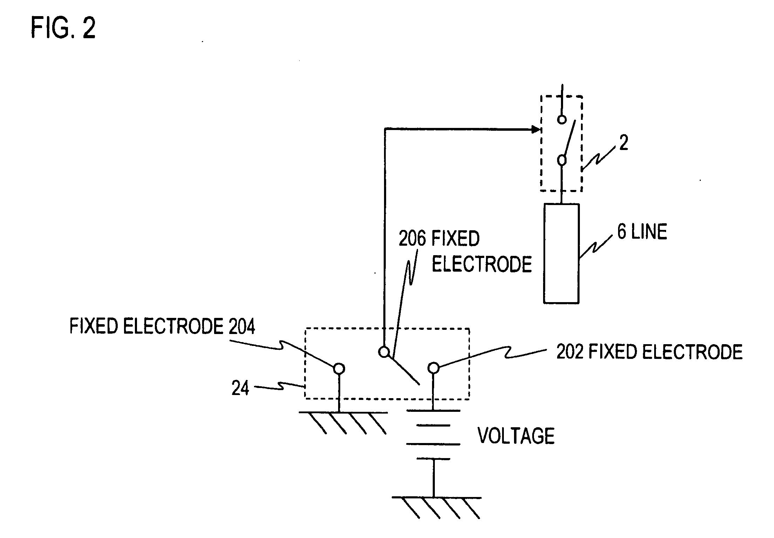

Fig. 2 is a detailed diagram showing the switch 24. For example, the switch 24 has two fixed electrodes 202 and 204 and one movable electrode 206. In the ON state, the movable electrode 206 is electrically connected to the fixed electrode 202, a voltage V is applied to the control terminal of the switch 2, and the multi-band power amplifier 3 operates at the frequency f2. When the switch 24 receives the command signal, the movable electrode 206 is electrically connected to the fixed electrode 204. Thus, the switch 24 stops application of the voltage to the control terminal of the switch 2, and the switch 2 is turned to the OFF state. Therefore, the multi-band power amplifier 3 operates at the frequency f1. The switch 26 has the same configuration as the switch 24. That is, when the controlling section 20 receives the first trigger and transmits the command signal to the switches 24 and 26, the switches 2 and 4 are turned from the ON state to the OFF state.

### [Modification 1]

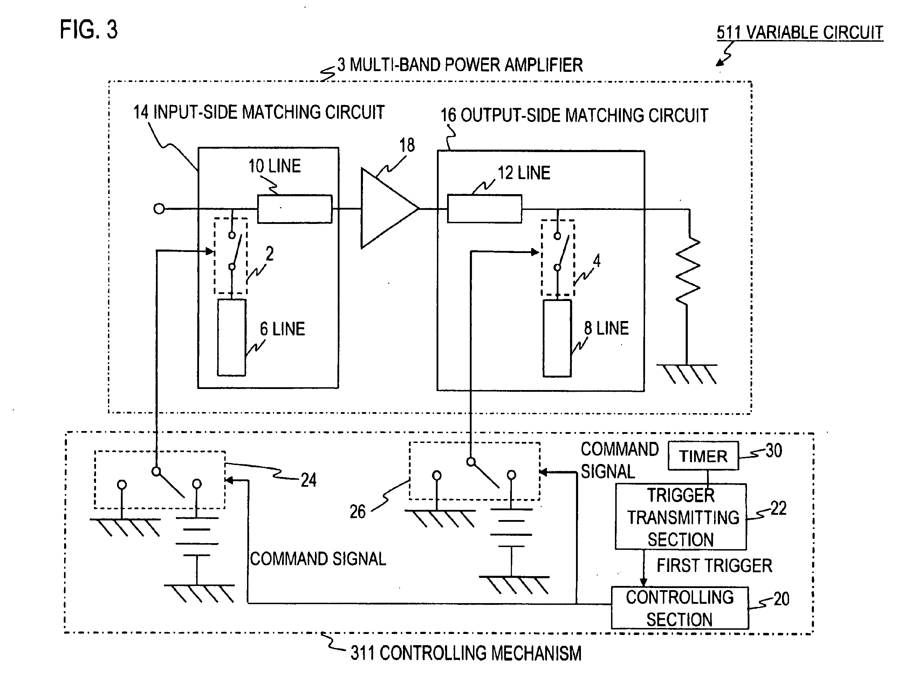

Fig. 3 is a diagram showing a functional configuration of a variable circuit 511 according to a modification 1 of the embodiment 1. The variable circuit 511 differs from the variable circuit 510 in that a controlling mechanism 311 has a timer 30. The timer 30 makes the trigger transmitting section 22 transmit the first trigger each time a first predetermined lapse time Δ T elapses. That is, each time the first predetermined lapse time ΔT elapses, the switches 2 and 4 are turned from the ON state to the OFF state. If the variable circuit 511 is not in use, the OFF state can be maintained. With such a configuration, the switches 2 and 4 are prevented from being maintained in the ON state for a long time, and fixation of the switches 2 and 4 are avoided.

### [Embodiment 2]

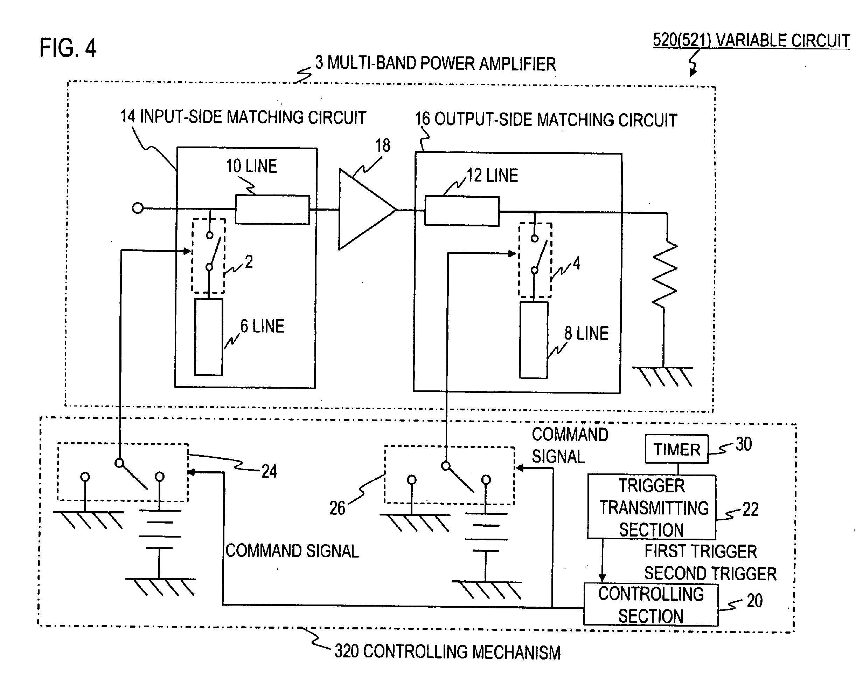

Fig. 4 is a diagram showing a functional configuration of a variable circuit 520 according to an embodiment 2. The variable circuit 520 differs from the variable circuit 511 in that a trigger transmitting section 22 in a controlling mechanism 320 transmits not only a first trigger but also a second trigger to a controlling section 20. When the controlling section 20 receives the second trigger, the controlling section 20 controls switches 2 and 4 by transmitting a command signal to return the switches 2 and 4 from the OFF state to the ON state. A timer 30 makes the trigger transmitting section 22 transmit the second trigger when a second predetermined lapse time δt elapses from the time when the switches are turned from the ON state to the OFF state.

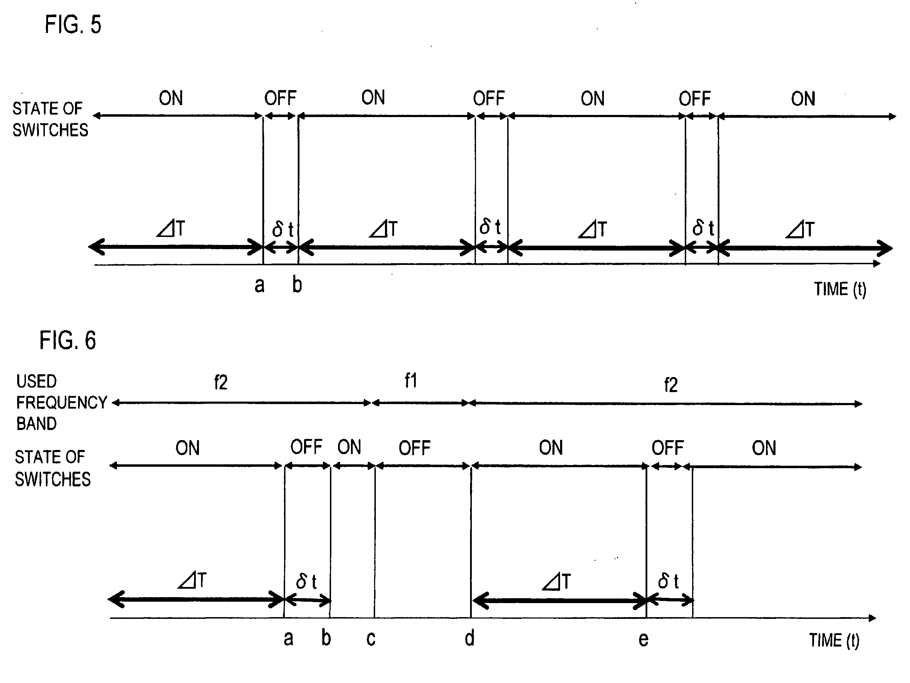

Fig. 5 is a diagram showing a relationship between the ON state and OFF state of the switches 2 and 4 and the first and second lapse times ΔT and δt. In a period between an arbitrary point in time and a first lapse time Δ T, the controlling section 20 transmits the control signal to switches 24 and 26, and the switches 2 and 4 are in the ON state. When the first lapse time ΔT elapses (at a point in time "a"), the trigger transmitting section 22 transmits the first trigger to the controlling section 20, and the controlling section 20 turns the switches 2 and 4 to the OFF state. The first lapse time Δ T is preferably shorter than a fixation time R, which is the time from the point in time when the switches 2 and 4 are turned to the ON state to the point in time when fixation of the switches 2 and 4 occurs. In this way, since the mechanical state of the switches is changed at intervals shorter than the fixation time R, problems, such as fixation of the switches 2 and 4, can be prevented.

However, after the point in time "a", the switches 2 and 4 are in the OFF state, so that the multi-band power amplifier 3 is in the f1 mode and cannot achieve optimal characteristics at the frequency f2. Thus, the timer 30 makes the trigger transmitting section 22 further transmit the second trigger when the second lapse time δt elapsed (at a point in time "b"). The controlling section 20 controls the switches 2 and 4 by transmitting a command signal to return the switches 2 and 4 to the ON state from the OFF state (or, in other words, to make the multi-band power amplifier 3 operate at the frequency f2). Therefore, the multi-band power amplifier 3 can achieve optimal characteristics. Here, the second lapse time δt is preferably minimized as far as the second lapse time δt does not affect the transfer characteristics of the variable circuit 520.

Furthermore, the timer 30 can measure the first lapse time ΔT from the point in time when the switches are turned from the OFF state to the ON state (the point in time "b"). With such a configuration, the variable circuit can operate without affecting the transfer characteristics as shown in Fig. 5.

In the variable circuit configured according to the embodiment 2, the controlling section 20 controls the switches 2 and 4 to turn the switches 2 and 4 from the ON state to the OFF state when the first lapse time ΔT elapses. In addition, the controlling section 20 returns the switches 2 and 4 to the ON state when the second lapse time δt elapses from the point in time when the switches are turned to the OFF state. Thus, fixation or the like of the switches 2 and 4 can be prevented without affecting the transfer characteristics.

### [Modification 1]

Next, a variable circuit 521 according to a modification 1 of the embodiment 2 will be described. The variable circuit 521 uses both the frequency bands f1 and f2. The variable circuit according to the modification 1 has the functional configuration shown in Fig. 4, and Fig. 6 shows a relationship between the frequency bands used and the state of the switches. In the case where the frequency band f2 is used, when the first lapse time ΔT elapses (at the point in time "a"), the switches 2 and 4 are turned to the OFF state under the control of the controlling section 20. Then, when the second lapse time δt elapses (at the point in time "b"), the switches 2 and 4 are turned to the ON state again. Then, the frequency band used is changed from f2 to f1 (at a point in time "c"). At the point in time "c", the time measurement of the timer 30 is reset. When the frequency band used is changed from f1 to f2 again (at a point in time "d"), the timer 30 starts time measurement again. Then, when the first lapse time ΔT elapses (at a point in time "e"), the switches 2 and 4 are turned to the OFF state under the control of the controlling section 20. Even for the variable circuit 521 that uses the two frequency bands f1 and f2, fixation or the like of the switches 2 and 4 can be prevented by operation of the timer 30, the trigger transmitting section 22 and the controlling section 20.

### [Modification 2]

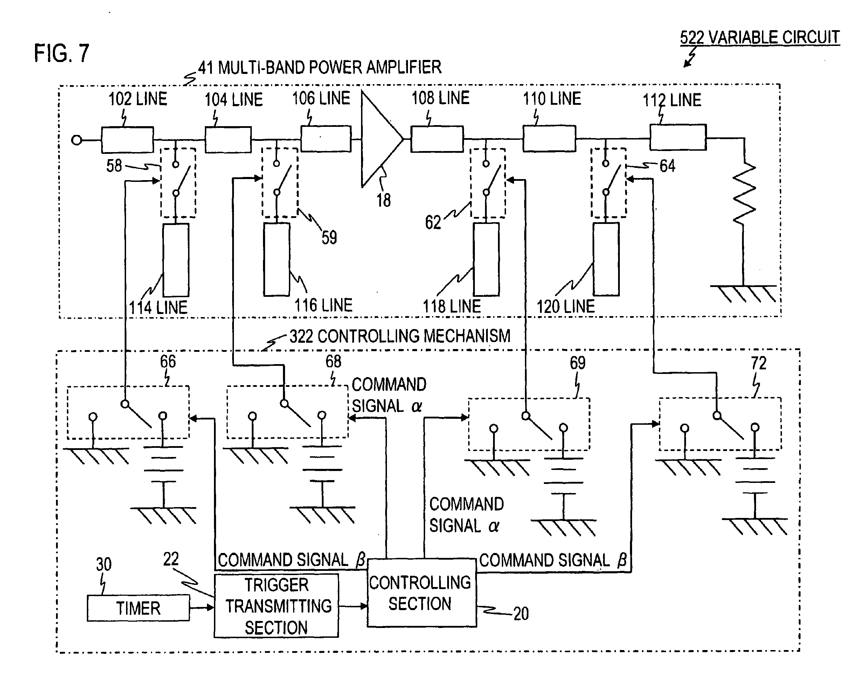

Fig. 7 is a diagram showing a functional configuration of a variable circuit 522 according to a modification 2 of the embodiment 2. A multi-band power amplifier 41 has lines 102, 104, 106, 108, 110, 112, 114, 116, 118 and 120, switches 58, 59, 62 and 64, and a single-band PA 18. The lines 102, 104, 106, 108, 110, 112, 114, 116, 118 and 120 are the same as the lines 10 and 12 (see Fig. 1), and the switches 58, 59, 62 and 64 are the same as the switches 2 and 4.

On the input side of the single-band PA 18, the lines 102, 104 and 106 for adjusting the frequency band are disposed. On the output side of the single-band PA 18, the lines 108, 110 and 112 for adjusting the frequency band are disposed. The controlling section 20 uses a command signal α to control switches 68 and 69, thereby controlling the switches 59 and 62. The controlling section 20 uses a command signal β to control switches 66 and 72, thereby controlling the switches 58 and 64. When the switches 59 and 62 are in the ON state, the multi-band power amplifier 41 operates at the frequency f1. When the switches 58 and 64 are in the ON state, the multi-band power amplifier 41 operates at the frequency f2.

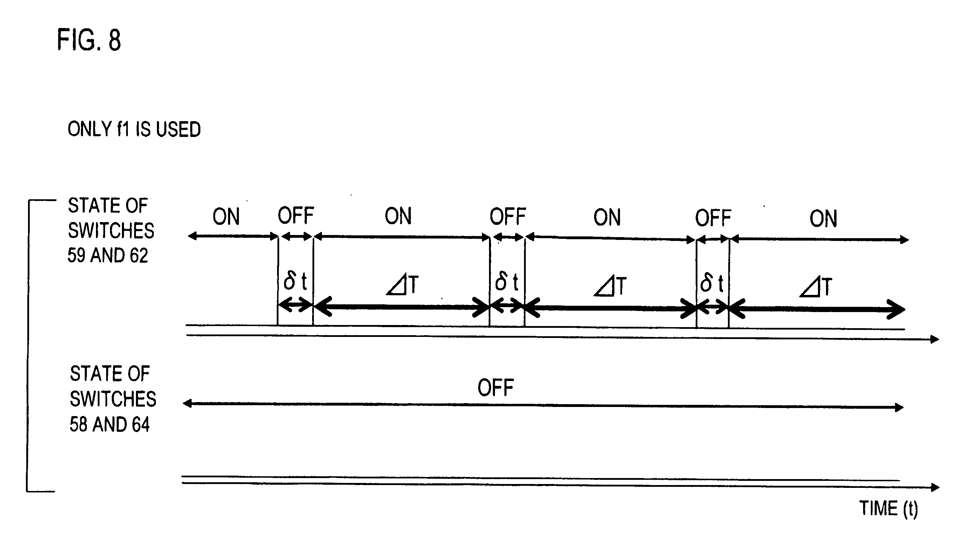

Fig. 8 shows a relationship between the ON and OFF states of the switches 58, 59, 62 and 64 and the first and second lapse times ΔT and δt in the case where the variable circuit 522 uses only the frequency band f1. As shown in Fig. 8, the controlling section 20 turns the switches 59 and 62 to the OFF state each time the first lapse time ΔT elapses from the point in time when the switches 59 and 62 are turned to the ON state. When the second lapse time δt elapses from the point in time when the switches 59 and 62 are turned to the OFF state, the controlling section 20 returns the switches 59 and 62 to the ON state. In this case, the frequency band f2 is not used, and therefore, the controlling section 20 does not transmit the control signal β.

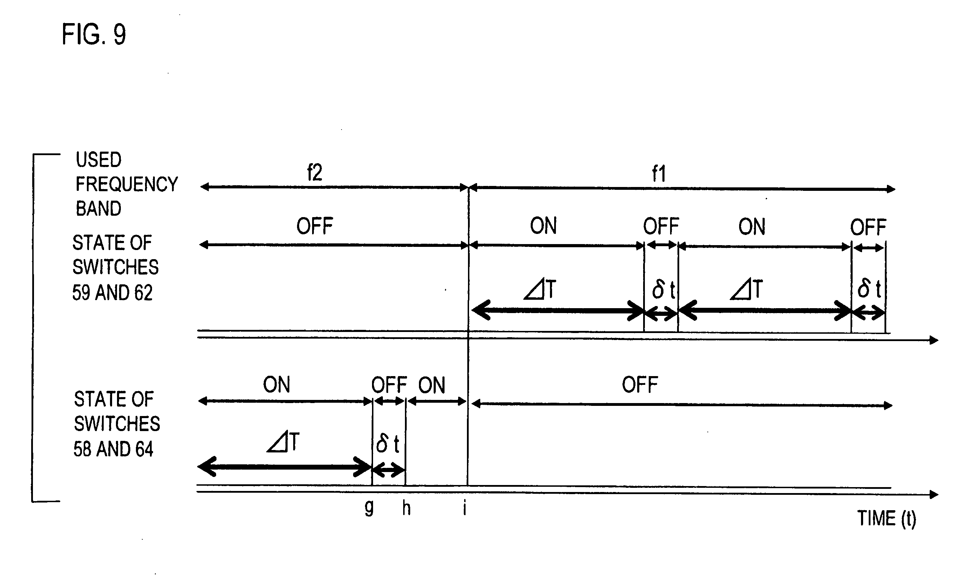

Fig. 9 shows a relationship between the ON and OFF states of the switches 59 and 62 and the first and second lapse times ΔT and δt in the case where the variable circuit 522 uses the frequency bands f1 and f2. As shown in Fig. 9, when the first lapse time ΔT elapses after the switches 58 and 64 are turned to the ON state (at a point in time "g"), the controlling section 20 turns the switches 58 and 64 to the OFF state. When the second lapse time δt elapses from the point in tine when the switches 58 and 64 are turned to the OFF state, the switches 58 and 64 are returned to the ON state (at a point in time "h"). The controlling section 20 does not transmit the command signal β but transmits the command signal α to switch the frequency band used from f2 to f1 (at a point in time "i"). Then, each time the first lapse time ΔT elapses, the switches 59 and 62 are turned to the OFF state. When the second lapse time δt elapses from the point in time when the switches 59 and 62 are turned to the OFF state, the switches 59 and 62 are returned to the ON state.

### [Embodiment 3]

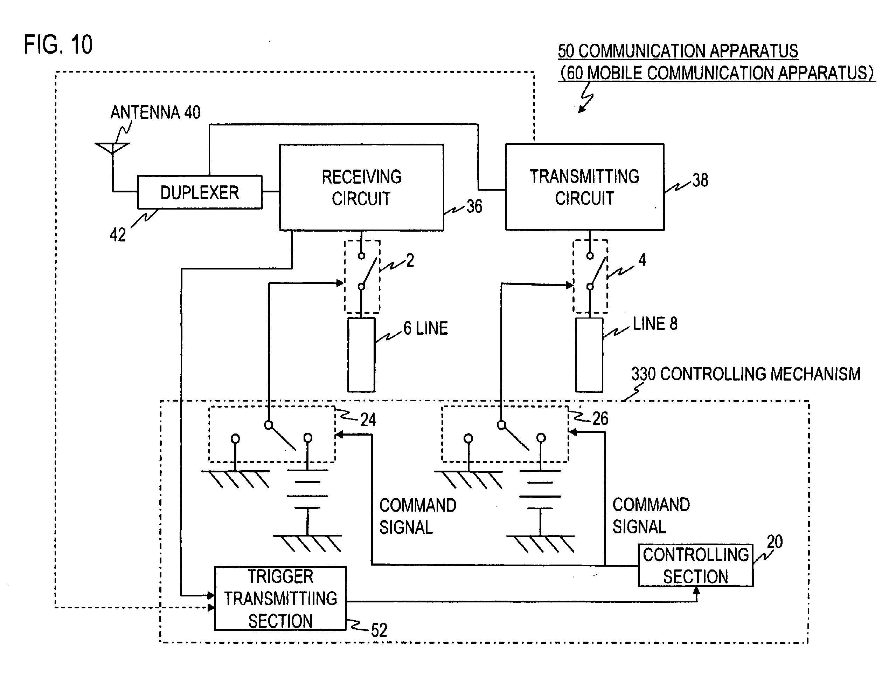

In an embodiment 3, a communication apparatus 50 that has a variable circuit, which is a modification of the variable circuits according to the embodiments 1 and 2 described above, will be described. Fig. 10 is a diagram showing a functional configuration of the communication apparatus 50 according to the embodiment 3. The communication apparatus 50 has a controlling mechanism 330, a receiving circuit 36, a transmitting circuit 38, switches 2 and 4, lines 6 and 8, a duplexer 42 and an antenna 40. The receiving circuit 36 receives an incoming signal from the antenna 40. The transmitting circuit 38 produces a transmission signal. The antenna 40 is used for transmitting the transmission signal or receiving the incoming signal. The duplexer 42 prevents the transmission signal from being input to the receiving circuit or the incoming signal from being input to the transmitting circuit.

In the embodiments 1 and 2, the timer 30 makes the trigger transmitting section 22 transmit the first trigger. However, the communication apparatus 50 (the controlling mechanism 330) does not have the timer 30 and is characterized in that a trigger transmitting section 52 does not transmit the first trigger when the communication apparatus 50 is in communication. That is, the trigger transmitting section 52 transmits the first trigger to the controlling section 20 when the communication apparatus 50 is not in communication.

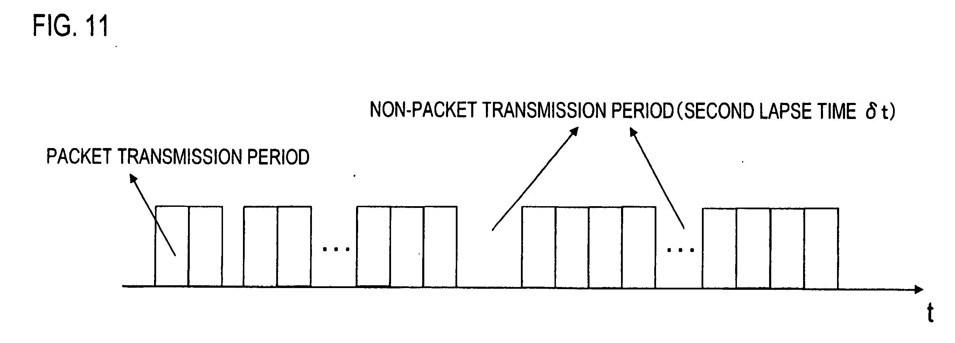

For example, consider packet communication. Fig. 11 is a schematic diagram illustrating packet communication as a function of time. The abscissa indicates time. Rectangles represent the period in which packets are transmitted. If the period in which no packet is transmitted (shown as "non-packet transmission period" in Fig. 11) is set to be equal to the second lapse time δt, the switches 2 and 4 can be turned to the OFF state to prevent fixation or the like of the switches 2 and 4 without interfering with the packet transmission.

### [Embodiment 4]

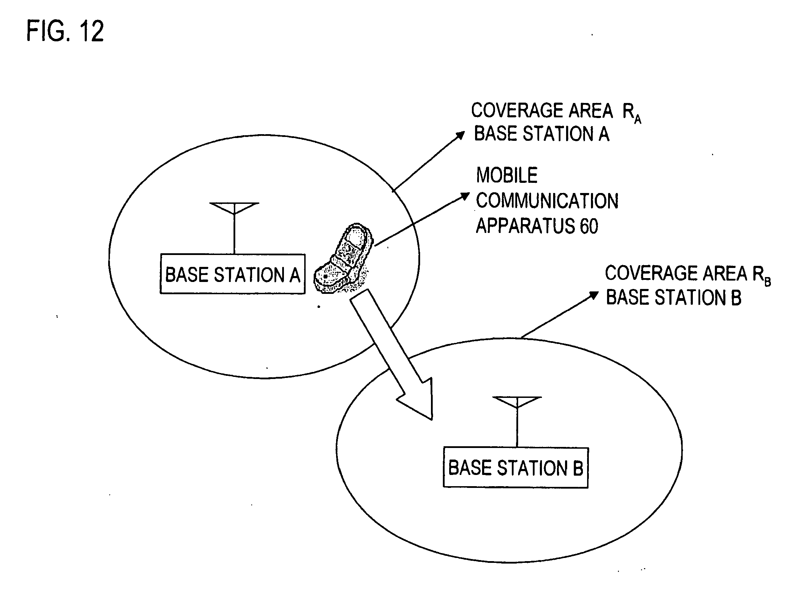

Next, a mobile communication apparatus 60 according to an embodiment 4 will be described. The mobile communication apparatus 60 communicates with a plurality of base stations. The mobile communication apparatus is a cellular phone, for example. The mobile communication apparatus 60 has the functional configuration shown in Fig. 10. It is supposed that the mobile communication apparatus 60 is currently located in a coverage area R_{A} of a base station A and communicates with the base station A as shown in Fig. 12. In addition, it is supposed that the mobile communication apparatus 60 then moves into a coverage area R_{B} of a base station B and switches from the base station A to the base station B. A trigger transmitting section 52 does not transmit a first trigger to a controlling section 20 at any time other than when the base station is switched. In other words, the trigger transmitting section 52 mainly transmits the first trigger to the controlling section 20 when the base station is switched.

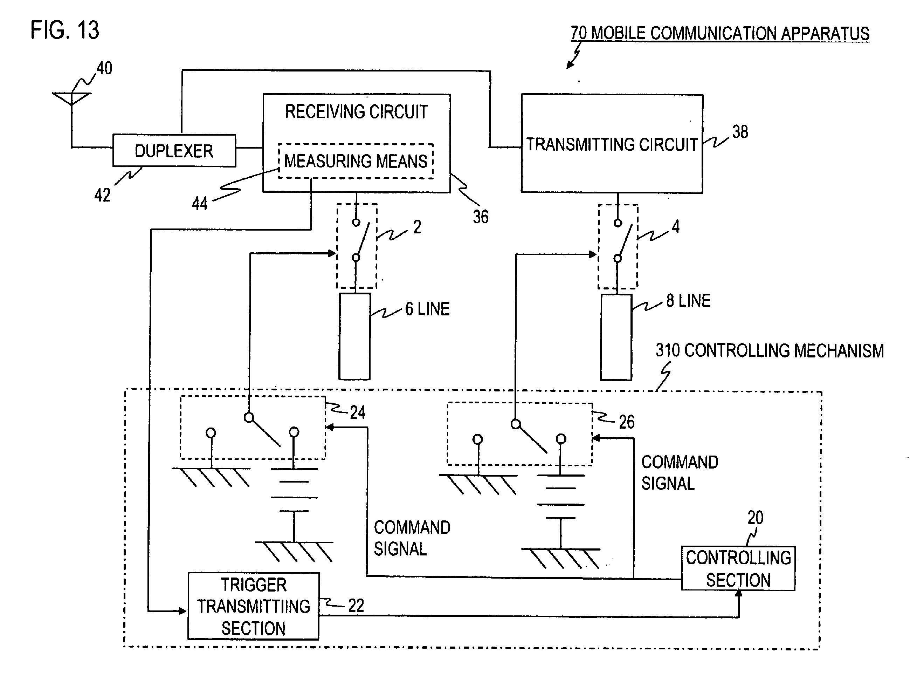

A mobile communication apparatus 70, which has a more specific configuration than the mobile communication apparatus 60, will be described. Fig. 13 is a diagram showing a functional configuration of the mobile communication apparatus 70. A receiving circuit 36 has measuring means 44. The measuring means 44 measures received signals from a plurality of base stations. The measuring means 44 determines that the base station is switched when a reception level L_{A} for a base station A (see Fig. 12) with which the mobile communication apparatus 70 is currently communicating becomes lower than a predetermined threshold L_{R}, and a reception level L_{B} for another base station B becomes higher than the threshold L_{R}. When the measuring means 44 makes that determination, the measuring means 44 makes a trigger transmitting section 22 transmit a first trigger to a controlling section 20.

Alternatively, the measuring means 44 can determine that the base station is switched only based on the fact that the reception level L_{A} for the base station A with which the mobile communication apparatus is communicating becomes lower than the threshold L_{R}. When the reception level L_{A} becomes lower than the threshold L_{R}, it can mean that the mobile communication apparatus moves out of the coverage area R_{A} of the base station A. When the measuring means 44 makes that determination, that is, when the base station is switched, or when the mobile communication apparatus moves out of the coverage area of the base station, the measuring means 44 makes the trigger transmitting section 22 transmit the first trigger to the controlling section 20.

### [Modification 1]

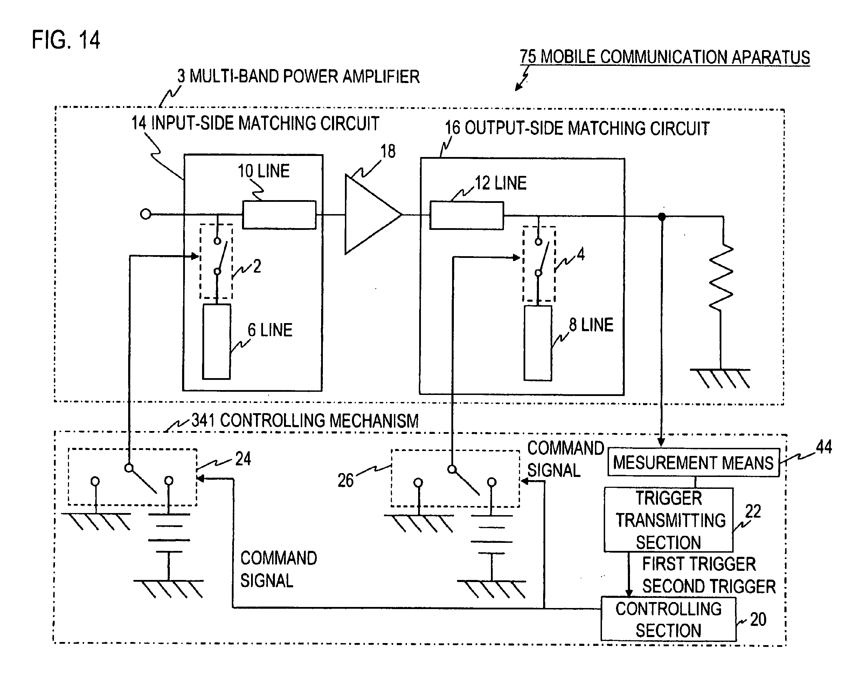

Next, a mobile communication apparatus 75, which is a modification 1 of the mobile communication apparatus 70, will be described. Fig. 14 is a diagram showing a functional configuration of a part of the mobile communication apparatus 75. The mobile communication apparatus 75 has the variable circuit described in the embodiments 1 and 2. Illustration of some of the components, such as an antenna, is omitted in Fig. 14. The mobile communication apparatus 75 has the measuring means 44 in a controlling mechanism 341. The measuring means 44 measures an output signal from an output-side matching circuit. The mobile communication apparatus 75 thus configured can achieve the same effects as the mobile communication apparatus 70.

### [Modification 2]

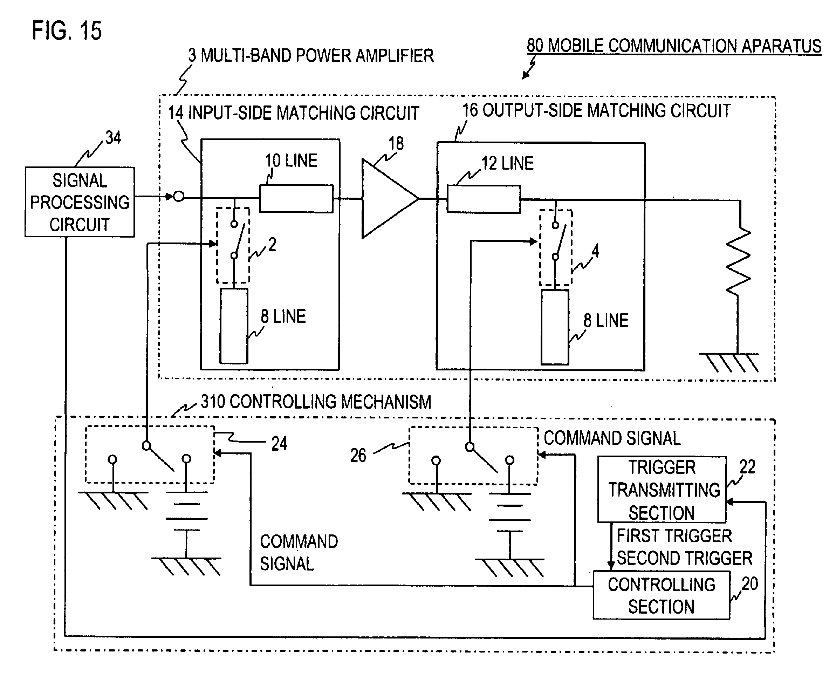

Next, a mobile communication apparatus 80, which is a modification 2 of the mobile communication apparatus 70, will be described. Fig. 15 is a diagram showing a functional configuration of the mobile communication apparatus 80. The mobile communication apparatus 80 has a signal processing circuit 34 in addition to the variable circuit described in the embodiments 1 and 2. The signal processing circuit 34 detects switch information indicating that the base station is switched. When the signal processing circuit 34 detects the switch information, the signal processing circuit 34 makes the trigger transmitting section 22 transmit the first trigger to the controlling section 20.

With such a configuration, switches 2 and 4 can be turned to the OFF state to prevent fixation or the like of switches 2 and 4 without interfering with the communication between base stations and the mobile communication apparatus.

### [Embodiment 5]

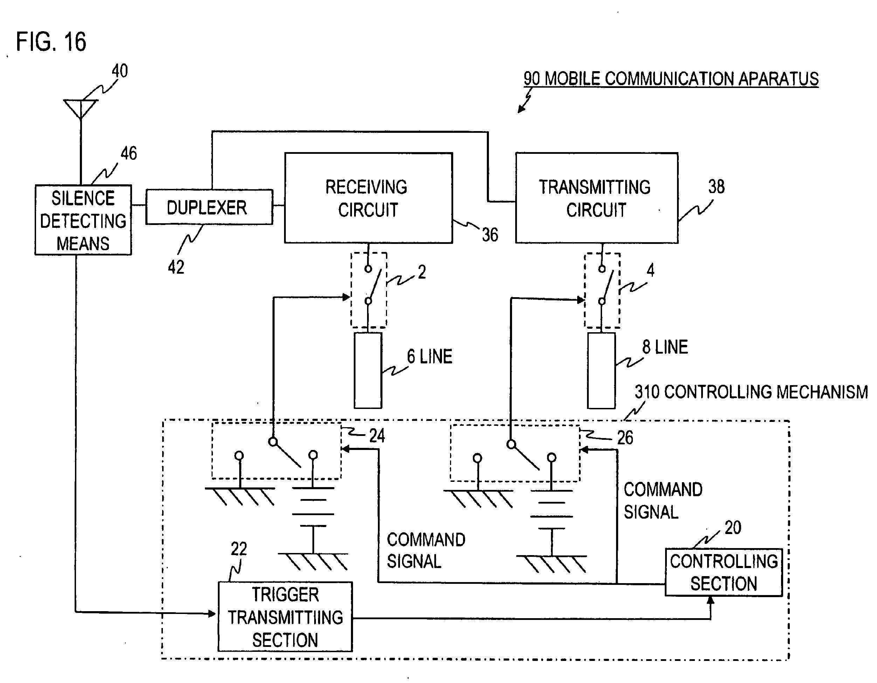

Fig. 16 is a diagram showing a functional configuration of a mobile communication apparatus 90 according to an embodiment 5. The mobile communication apparatus 90 differs from the mobile communication apparatus 60 (see Fig. 10) in that the mobile communication apparatus 90 has silence detecting means 46 between an antenna 40 and a duplexer 42. The silence detecting means 46 detects the state of communication. A trigger transmitting section 22 does not transmit a first trigger during communication unless the silence detecting means 46 determines that the communication is in a silent state. In other words, during communication, the trigger transmitting section 22 mainly transmits the first trigger when the silence detecting means 46 determines that the communication is in a silent state.

With such a configuration, even during communication, switches 2 and 4 can be turned to the OFF state to prevent fixation or the like of the switches 2 and 4 without interfering with the communication processing.

### [Embodiment 6]

A mobile communication apparatus according to an embodiment 6 will be described with reference to Fig. 10. A trigger transmitting section 52 transmits a first trigger when communication is started or ended. More specifically, the trigger transmitting section 52 determines that communication is started when a receiving circuit 36 receives an incoming signal or a transmitting circuit 38 transmits a transmission signal (indicated by the dashed arrow in Fig. 10), for example. The trigger transmitting section 52 determines that communications is ended when an incoming signal or transmission signal is no longer detected. As described above, the trigger transmitting section 52 transmits the first trigger when the trigger transmitting section 52 determines that communication is started or ended. With such a configuration, switches 2 and 4 can be turned to the OFF state to prevent fixation or the like of the switches 2 and 4 without interfering with the communication processing.

### [Embodiment 7]

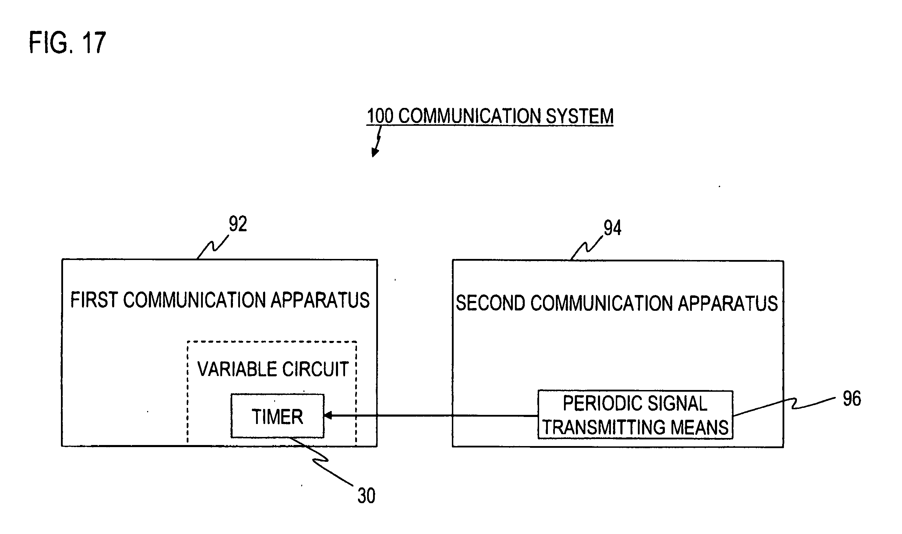

Next, a communication system 100 according to an embodiment 7. Fig. 17 is a diagram showing a functional configuration of the communication system 100. The communication system 100 has a first communication apparatus 92 and a second communication apparatus 94. The first communication apparatus 92 has the variable circuit 511 (see Fig. 3) described in the embodiment 1 or the variable circuit 520 (see Fig. 4), for example. The second communication apparatus 94 has periodic signal transmitting means 96 that periodically transmits a periodic signal to the first communication apparatus 92. A timer 30 in the first communication apparatus measures time based on the periodic signal, and a trigger transmitting section 22 in the first communication apparatus 92 does not transmit a first trigger at any time other than when the periodic signal is received. In other words, the trigger transmitting section 22 mainly transmits the first trigger when the periodic signal is received.

### [Modifications of switches]

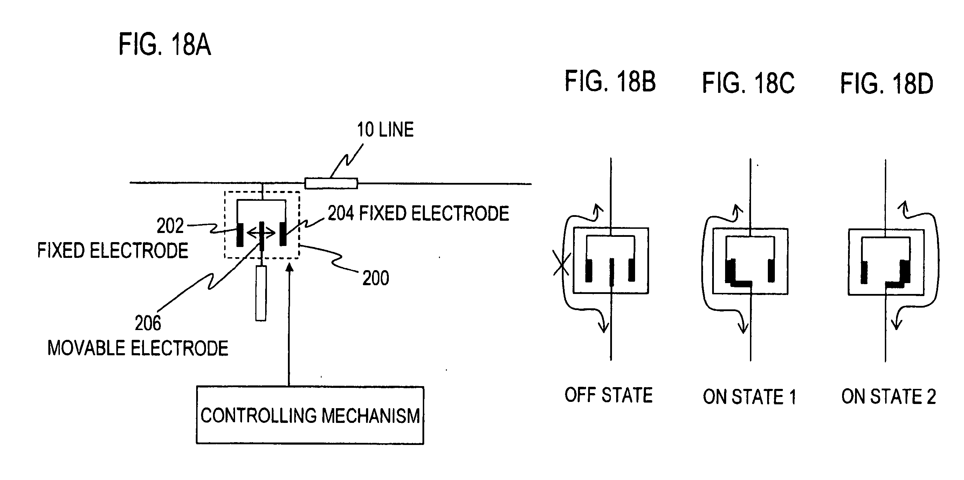

The switches 2 and 4 described above are single-pole single-throw switches. However, a modification of the switches 2 and 4 (see Fig. 1) as described below is possible (referred to as switch 200, hereinafter). Fig. 18A is a diagram showing a functional configuration of the switch 200. The switch 200 has two fixed electrodes 202 and 204 and one movable electrode 206. As shown in Fig. 18B, when a controlling mechanism does not apply a voltage V to the switch 200, the switch 200 is in the OFF state. When the voltage V is applied to the switch 200, the movable electrode 206 comes into electrical contact with one of the fixed electrodes 202 and 204. In any of the cases where the movable electrode 206 comes into contact with the fixed electrode 202 as shown in Fig. 18C (this state will be referred to as ON state 1, hereinafter) and where the movable electrode 206 comes into contact with the fixed electrode 204 as shown in Fig. 18D (this state will be referred to as ON state 2, hereinafter), the switch 200 is turned to the ON state. The switch 200 is in the OFF state when the switch 200 changes from the ON state 1 to the ON state 2 or from the ON state 2 to the ON state 1. The switches 2 and 4 thus configured reduce the load on the fixed electrodes and change between the ON state and the OFF state more smoothly.

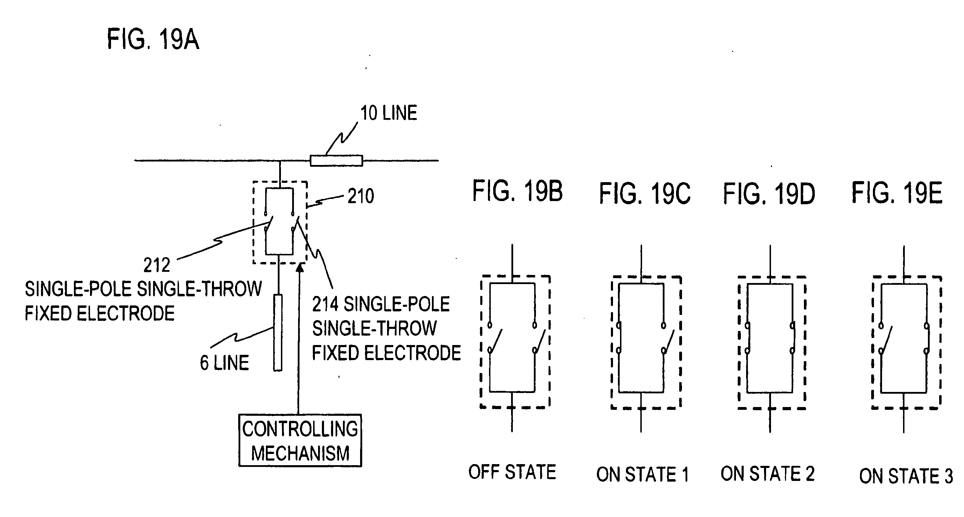

Figs. 19A to 19E show another modification of the switches 2 and 4 (referred to as switch 210, hereinafter). The switch 210 has two single-pole single-throw switches 212 and 214 connected parallel with each other. The switch 210 thus configured is turned to the OFF state when both the single-pole single-throw switches 212 and 214 are opened as shown in Fig. 19B and is turned to the ON state when at least one of the single-pole single-throw switches 212 and 214 is closed as shown in Figs. 19C, 19D and 19E. Specifically, in the case where the initial current state is the ON state shown in Fig. 19C, a controlling section in a controlling mechanism controls the switches in such a manner that the switches are turned by a first trigger from the ON state shown in Fig. 19C to the ON state shown in Fig. 19D, which is the different state, turned by a second trigger from the ON state shown in Fig. 19D to the ON state shown in Fig. 19E, which is the next current state, turned by the first trigger from the ON state shown in Fig. 19E to the ON state shown in Fig. 19D, which is the different state, and then turned by the second trigger from the ON state shown in Fig. 19D to the ON state shown in Fig. 19C, which is the initial current state, for example. That is, in this case, although the state of the switches is successively changed, the ON state is maintained. Alternatively, in the case where the initial current state is the OFF state shown in Fig. 19B, the controlling section in the controlling mechanism controls the switches in such a manner that the switches are turned by the first trigger from the OFF state shown in Fig. 19B to the ON state shown in Fig. 19D, which is the different state, and then turned by the second trigger from the ON state shown in Fig. 19D to the OFF state shown in Fig. 19B, which is the current state.

If the switch 210, which has two switches that successively operate in a make-before-break (MBB) manner, is used in a circuit that is required to maintain the ON state for a long time, fixation or the like of the switch can be prevented without causing any instantaneous disconnection when the ON state is maintained for a long time.

The present invention is not limited to the embodiments described above. For example, while line stubs are used for frequency matching in the embodiments described above, a lumped-parameter reactance element can also be used. In that case, instead of the line conductor stubs in the embodiments described above, reactance elements are connected to the switches 2 and 4. In other respects, various modifications are possible without departing from the spirit of the present invention. In the embodiments described above, two frequency bands are used. However, even if the number of switches is increased, or the combination of the ON state and the OFF state of the switches is changed, fixation or the like of the switches 2 and 4 can be prevented by the same control.

### INDUSTRIAL APPLICABILITY

Applications of the present invention include a communication apparatus used in a wide frequency band, such as an RF circuit element used in a multi-band cellular phone terminal.

## Claims

1. A variable circuit that has a MEMS switch (2, 4) that changes the mechanical state thereof and has a characteristic that is changed by a change of the mechanical state of the MEMS switch (2, 4), the variable circuit comprising:
a multi-band power amplifier (3) that has said MEMS switch (2, 4) as a part of its matching circuit (14, 16);
a controlling section (20) that turns said MEMS switch (2, 4) from a current state, which is a current mechanical state, to a different state, which is a state different from the current state, and returns said MEMS switch (2, 4) from said different state to said current state;
a trigger transmitting section (22) that transmits a first trigger to turn said MEMS switch (2, 4) from said current state to said different state and a second trigger to return said MEMS switch (2, 4) from said different state to said current state to said controlling section (20) **characterized in that**
a timer (30) that measures time and makes said trigger transmitting section (22) transmit said first trigger and said second trigger by predetermined timings.

2. The variable circuit according to Claim 1, wherein said
timer (30) makes said trigger transmitting section (22) transmit said first trigger each time a first predetermined lapse time elapses and said second trigger when a second predetermined lapse time elapses from a point in time when said MEMS switch (2, 4) is turned from said current state to said different state.

3. The variable circuit according to Claim 2, wherein said timer (30) measures said first lapse time from a point in time when a frequency band used is changed.

4. The variable circuit according to any of Claims 1 to 3, wherein said MEMS switch (200) has a movable electrode (206), a first fixed electrode (202) and a second fixed electrode (204), the movable electrode (206) moves to alternately come into contact with said first fixed electrode (202) and said second fixed electrode (204) in response to said first trigger or said second trigger, and said current state and said different state are any of a state in which the movable electrode (206) is in contact with any of the fixed electrodes (202, 204) and a state in which the movable electrode (206) is not in contact with any of the fixed electrodes (202,204).

5. The variable circuit according to any of Claims 1 to 3, wherein said MEMS switch (210) has two single-pole single throw switches (212, 214) connected in parallel to each other, each single-pole single-throw switch (212, 214) opens or closes in response to said first trigger or said second trigger, and the variable circuit is configured so that said current state is a state in which any one of the switches (212, 214) is opened, said different state is a state in which both the switches (212, 214) are closed, and different switches (212, 214) are opened when said MEMS switch (210) is in the current state before being turned to the different state and when said MEMS switch (210) is in the current state after being returned from the different state or so that said current state is a state in which both the switches (212, 214) are opened, and said different state is a state in which both the switches (212, 214) are closed.

6. The variable circuit according to any of Claims 1 to 5, wherein said current state is that said MEMS switch (2, 4) is in the ON state,
said different state is that said MEMS switch (2, 4) is in the OFF state, and said trigger transmitting section (22) further transmits said first trigger when the variable circuit has begun to be used and/or finished being used.

7. The variable circuit according to Claim 1, further comprising:
a periodic signal receiving means that periodically receives a periodic signal,
wherein said current state is that said MEMS switch (2, 4) is in the ON state,
said different state is that said MEMS switch (2, 4) is in the OFF state,
said timer (30) measures time based on said periodic signal, and said trigger transmitting section (22) does not transmit said first trigger at any time other than when said periodic signal is received.

## Patentansprüche

1. Variable Schaltung, die einen MEMS-Schalter (2, 4) aufweist, der deren mechanischen Zustand ändert, und die eine Kennlinie aufweist, die durch eine Änderung des mechanischen Zustands des MEMS-Schalters (2, 4) geändert wird, wobei die variable Schaltung Folgendes umfasst:
einen Mehrband-Leistungsverstärker (3), der den MEMS-Schalter (2, 4) als Teil seiner Anpassungsschaltung (14, 16) aufweist;
einen Steuerabschnitt (20), der den MEMS-Schalter (2, 4) von einem aktuellen Zustand, bei dem es sich um einen aktuellen mechanischen Zustand handelt, in einen anderen Zustand, bei dem es sich um einen anderen Zustand als den aktuellen Zustand handelt, versetzt und den MEMS-Schalter (2, 4) von dem anderen Zustand in den aktuellen Zustand zurückversetzt;
einen Trigger-Sendeabschnitt (22), der einen ersten Trigger, um den MEMS-Schalter (2, 4) von dem aktuellen Zustand in den anderen Zustand zu versetzen, und einen zweiten Trigger, um den MEMS-Schalter (2, 4) von dem anderen Zustand in den aktuellen Zustand zurückzuversetzen, an den Steuerabschnitt (20) sendet;
**dadurch gekennzeichnet, dass**
ein Zeitmesser (30), der die Zeit misst und bewirkt, dass der Trigger-Sendeabschnitt (22) den ersten Trigger und den zweiten Trigger zu vorbestimmten Zeiteinstellungen sendet.

2. Variable Schaltung nach Anspruch 1, wobei der Zeitmesser (30) bewirkt, dass der Trigger-Sendeabschnitt (22) den ersten Trigger jedes Mal, wenn eine erste vorbestimmte Zeitspanne verstreicht, und den zweiten Trigger, wenn eine zweite Zeitspanne verstreicht, ab einem Zeitpunkt, an dem der MEMS-Schalter (2, 4) von dem aktuellen Zustand in den anderen Zustand versetzt wird, sendet.

3. Variable Schaltung nach Anspruch 2, wobei der Zeitmesser (30) die erste Zeitspanne ab einem Zeitpunkt misst, an dem ein verwendeter Frequenzbereich geändert wird.

4. Variable Schaltung nach einem der Ansprüche 1 bis 3, wobei der MEMS-Schalter (200) eine bewegliche Elektrode (206), eine erste feststehende Elektrode (202) und eine zweite feststehende Elektrode (204) aufweist, sich die bewegliche Elektrode (206) bewegt, um abwechselnd mit der ersten feststehenden Elektrode (202) und der zweiten feststehenden Elektrode (204) als Reaktion auf den ersten Trigger oder den zweiten Trigger in Kontakt zu kommen, und der aktuelle Zustand und der andere Zustand einer von einem Zustand, in dem die bewegliche Elektrode (206) in Kontakt mit einer der feststehenden Elektroden (202, 204) steht, und einem Zustand, in dem die bewegliche Elektrode (206) nicht in Kontakt mit einer der feststehenden Elektroden (202, 204) steht, sind.

5. Variable Schaltung nach einem der Ansprüche 1 bis 3, wobei der MEMS-Schalter (210) zwei einpolige Ausschalter (212, 214) aufweist, die zueinander parallel geschaltet sind, wobei sich jeder einpolige Ausschalter (212, 214) als Reaktion auf den ersten Trigger oder den zweiten Trigger öffnet oder schließt, und die variable Schaltung derart konfiguriert ist, dass der aktuelle Zustand ein Zustand ist, in dem einer der Schalter (212, 214) geöffnet ist, der andere Zustand ein Zustand ist, in dem die beiden Schalter (212, 214) geschlossen sind, und verschiedene Schalter (212, 214) geöffnet sind, wenn sich der MEMS-Schalter (210) in dem aktuellen Zustand befindet, bevor er in den anderen Zustand versetzt wird, und wenn sich der MEMS-Schalter (210) in dem aktuellen Zustand befindet, nachdem er aus dem anderen Zustand zurückversetzt wurde, oder dass der aktuelle Zustand ein Zustand ist, in dem die beiden Schalter (212, 214) geöffnet sind, und der andere Zustand ein Zustand ist, in dem die beiden Schalter (212, 214) geschlossen sind.

6. Variable Schaltung nach einem der Ansprüche 1 bis 5, wobei
der aktuelle Zustand darin besteht, dass sich der MEMS-Schalter (2, 4) im EIN-Zustand befindet,
der andere Zustand darin besteht, dass sich der MEMS=Schalter (2, 4) im AUS-Zustand befindet, und
der Trigger-Sendeabschnitt (22) ferner den ersten Trigger sendet, wenn die Verwendung der variablen Schaltung begonnen hat und/oder beendet ist.

7. Variable Schaltung nach Anspruch 1, ferner umfassend:
ein Mittel zum Empfangen eines periodischen Signals, das periodisch ein periodisches Signal empfängt,
wobei der aktuelle Zustand darin besteht, dass sich der MEMS-Schalter (2, 4) im EIN-Zustand befindet,
der andere Zustand darin besteht, dass sich der MEMS-Schalter (2, 4) im AUS-Zustand befindet,
der Zeitmesser (30) die Zeit basierend auf dem periodischen Signal misst, und
der Trigger-Sendeabschnitt (22) den ersten Trigger zu keiner anderen Zeit sendet, als wenn das periodische Signal empfangen wird.

## Revendications

1. Circuit variable qui a un commutateur MEMS (2, 4) qui change l'état mécanique de celui-ci et a une caractéristique qui est changée par un changement de l'état mécanique du commutateur MEMS (2, 4), le circuit variable comprenant :
un amplificateur de puissance multibande (3) qui a ledit commutateur MEMS (2, 4) comme une partie de son circuit d'adaptation (14, 16) ;
une section de commande (20) qui fait passer ledit commutateur MEMS (2, 4) d'un état actuel, qui est un état mécanique actuel, à un état différent, qui est un état différent de l'état actuel, et refait passer ledit commutateur MEMS (2, 4) dudit état différent audit état actuel ;
une section de transmission de déclencheur (22) qui transmet un premier déclencheur pour faire passer ledit commutateur MEMS (2, 4) dudit état actuel audit état différent et un second déclencheur pour refaire passer ledit commutateur MEMS (2, 4) dudit état différent audit état actuel à ladite section de commande (20), **caractérisé en ce que**
un temporisateur (30) qui mesure le temps et amène ladite section de transmission de déclencheur (22) à transmettre ledit premier déclencheur et ledit second déclencheur par des positionnements temporels prédéterminés.

2. Circuit variable selon la revendication 1, dans lequel ledit temporisateur (30) amène ladite section de transmission de déclencheur (22) à transmettre ledit premier déclencheur chaque fois qu'un premier laps de temps prédéterminé s'écoule et ledit second déclencheur lorsqu'un second laps de temps prédéterminé s'écoule à partir d'un point dans le temps où ledit commutateur MEMS (2, 4) est passé dudit état actuel audit état différent.

3. Circuit variable selon la revendication 2, dans lequel ledit temporisateur (30) mesure ledit premier laps de temps à partir d'un point dans le temps où une bande de fréquences utilisée est changée.

4. Circuit variable selon l'une quelconque des revendications 1 à 3, dans lequel ledit commutateur MEMS (200) a une électrode mobile (206), une première électrode fixe (202) et une seconde électrode fixe (204), l'électrode mobile (206) se déplace pour venir alternativement en contact avec ladite première électrode fixe (202) et ladite seconde électrode fixe (204) en réponse audit premier déclencheur ou audit second déclencheur, et ledit état actuel et ledit état différent sont l'un quelconque d'un état dans lequel l'électrode mobile (206) est en contact avec l'une quelconque des électrodes fixes (202, 204) et d'un état dans lequel l'électrode mobile (206) n'est pas en contact avec aucune des électrodes fixes (202, 204).

5. Circuit variable selon l'une quelconque des revendications 1 à 3, dans lequel ledit commutateur MEMS (210) a deux commutateurs unipolaires à une direction (212, 214) connectés en parallèle l'un à l'autre, chaque commutateur unipolaire à une direction (212, 214) s'ouvre ou se ferme en réponse audit premier déclencheur ou audit second déclencheur, et le circuit variable est configuré de sorte que ledit état actuel soit un état dans lequel l'un quelconque des commutateurs (212, 214) est ouvert, ledit état différent est un état dans lequel les deux commutateurs (212, 214) sont fermés, et des commutateurs différents (212, 214) sont ouverts lorsque ledit commutateur MEMS (210) est dans l'état actuel avant d'être passé à l'état différent et lorsque ledit commutateur MEMS (210) est dans l'état actuel après être repassé de l'état différent ou de sorte que ledit état actuel soit un état dans lequel les deux commutateurs (212, 214) sont ouverts, et ledit état différent est un état dans lequel les deux commutateurs (212, 214) sont fermés.

6. Circuit variable selon l'une quelconque des revendications 1 à 5, dans lequel ledit état actuel est que ledit commutateur MEMS (2, 4) est dans l'état MARCHE,
ledit état différent est que ledit commutateur MEMS (2, 4) est dans l'état ARRRET, et
ladite section de transmission de déclencheur (22) transmet en outre ledit premier déclencheur lorsque le circuit variable a commencé à être utilisé et/ou fini d'être utilisé.

7. Circuit variable selon la revendication 1, comprenant en outre :
un moyen de réception de signal périodique qui reçoit périodiquement un signal périodique,
dans lequel ledit état actuel est que ledit commutateur MEMS (2, 4) est dans l'état MARCHE,
ledit état différent est que ledit commutateur MEMS (2, 4) est dans l'état ARRRET,
ledit temporisateur (30) mesure le temps sur la base dudit signal périodique, et
ladite section de transmission de déclencheur (22) ne transmet ledit premier déclencheur à aucun moment autre que lorsque ledit signal périodique est reçu.
